(19) Europäisches Patentamt
European Patent Office
Office européen des brevets

(11) **EP 2 287 918 A2**

(12) **EUROPEAN PATENT APPLICATION**
published in accordance with Art. 153(4) EPC

(43) Date of publication:
**23.02.2011 Bulletin 2011/08**

(21) Application number: **09754652.7**

(22) Date of filing: **25.05.2009**

(51) Int Cl.:
**H01L 31/04** (2006.01)    **G01J 1/00** (2006.01)
**G01M 11/00** (2006.01)

(86) International application number:
**PCT/JP2009/059528**

(87) International publication number:
**WO 2009/145144 (03.12.2009 Gazette 2009/49)**

(84) Designated Contracting States:
**AT BE BG CH CY CZ DE DK EE ES FI FR GB GR
HR HU IE IS IT LI LT LU LV MC MK MT NL NO PL
PT RO SE SI SK TR**
Designated Extension States:
**AL BA RS**

(30) Priority: **26.05.2008 JP 2008136771**

(71) Applicant: **NPC Incorporated
Arakawa-ku
Tokyo 116-0003 (JP)**

(72) Inventors:
• **HASHIMOTO, Toru
Tokyo 116-0003 (JP)**
• **TOGAWA, Yoshimasa
Tokyo 116-0003 (JP)**
• **ITO, Tomoaki
Tokyo 116-0003 (JP)**
• **NAKANISHI, Yuji
Tokyo 116-0003 (JP)**

(74) Representative: **Samson & Partner
Widenmayerstrasse 5
80538 München (DE)**

(54) **APPARATUS FOR EVALUATING THE OUTPUT CHARACTERISTIC OF A SOLAR BATTERY AND METHOD FOR EVALUATING THE OUTPUT CHARACTERISTIC OF A SOLAR BATTERY**

(57)    To provide a solar cell output characteristic evaluation apparatus and a method thereof capable of accurately measuring an open-circuit voltage Voc by applying a forward bias current with a minimum power consumption without requiring a bipolar power supply discharging a large current causing a cost increase.
    [ORGANIZATION]

    A solar cell output characteristic evaluation apparatus measuring output characteristic of a solar cell, including: a solar cell; a voltmeter measuring a voltage of the solar cell; an ammeter measuring a current value flowing in the solar cell; a variable resistor part connected to the solar cell; a forward bias circuit connected to the solar cell; and a reverse bias circuit connected to the solar cell is provided.

FIG.3

## Description

[Technical Field]

The present invention relates to a solar cell output characteristic evaluation apparatus and a solar cell output characteristic evaluation method including a forward bias power supply supplying an electronic load device for a solar cell output characteristic measurement.

[Background]

In recent years, a large size and high capacity solar cell has been achieved, and a solar cell of which output current is 10 A or more and output voltage is 200 V or more has been manufactured. Performance of the solar cell when it receives solar light is evaluated by I-V characteristic of the solar cell.
An apparatus and a method using a variable resistor are popular as a measurement apparatus and a method evaluating the I-V characteristic of the solar cell, and the apparatuses and the methods using a capacitor load, a bias power supply, an electronic load as the variable resistor are known (refer to Non-Patent Document 1).
However, there are a problem in which a short-circuit current Isc cannot be measured accurately caused by a connecting wire resistance or the like in the above-stated respective I-V characteristic evaluation methods of the solar cell, and a problem in which an open-circuit voltage Voc cannot be accurately measured caused by an effect of a breaking current of a transistor or the like in the above-stated method using the electronic load.
The present inventors invented a capacitor load type solar cell I-V curve tracer including a reverse bias circuit applying an electric potential with reversed polarity of an output off the solar cell in Patent Document 1.

[Non-Patent Document 1]

Solar cell measurement system (Eko Instruments Co., Ltd. Homepage)

[Patent Document 1]

Japanese Patent Application Publication No. Hei 2-159588

[Disclosure of the Invention]

[Problems to Be Solved by the Invention]

However, there has been a problem in which the short-circuit current Isc can be measured accurately because the reverse bias circuit is provide, but the open-circuit voltage Voc cannot be measured accurately because there isn't a forward bias function when the I-V characteristic evaluation of the solar cell is performed by using the capacitor load type solar cell I-V curve tracer describe in the above-stated Patent Document 1.
Besides, a power supply called as a bipolar power supply is used in the above-stated bias power supply type I-V characteristic evaluation of the solar cell, and a bipolar application is possible for both current and voltage. However, a supply and receive power capacity capable of sustaining electric power of a solar cell being a measurement object is required for the power supply used for the I-V characteristic evaluation of the solar cell, and therefore, a cost increasing resulting from large size becomes a problem in the high capacity bipolar power supply discharging a large current.
In consideration of the above-stated problems, an object of the present invention is to provide a solar cell output characteristic evaluation apparatus and a method thereof capable of accurately measuring the open-circuit voltage Voc by applying the forward bias current with a minimum power consumption without requiring the bipolar power supply discharging/absorbing the large current causing a cost increase.

[Means for Solving the Problems]

According to the present invention, a solar cell output characteristic evaluation apparatus measuring output characteristic of a solar cell, including: a solar cell; a voltmeter measuring a voltage of the solar cell; an ammeter measuring a current value flowing in the solar cell; a variable resistor part connected to the solar cell; a forward bias circuit connected to the solar cell; and a reverse bias circuit connected to the solar cell, is provided.
The variable resistor part may be made up of an electronic load control circuit and a load power semiconductor
The forward bias circuit may be made up of a forward bias resistor, a forward bias power supply and a forward bias parasitic current compensation circuit.

The variable resistor part and the reverse bias circuit are included in a power conversion circuit with reverse bias, and the power conversion circuit with reverse bias may be made up of a switching transformer, a backflow preventing diode, a reverse bias stabilizing capacitor and a load circuit,

Besides, according to another aspect of the present invention, a solar cell output characteristic evaluation method in which a voltmeter, an ammeter and an electronic load being a variable resistor are connected to a solar cell, and current-voltage characteristic of the solar cell are obtained by changing the electronic load, including: applying a reverse bias voltage in reverse of an output of the solar cell; applying a forward bias voltage to the solar cell; and measuring a short-circuit current and an open-circuit voltage of the solar cell is provided.

In the applying the forward bias voltage, a function restricting a maximum output voltage may be added to the forward bias power supply.

A high capacity electronic load device using a switching system may be used as the variable resistor.

A noise component may be removed from an output voltage, an output current obtained from the solar cell, and actual measured values of a monitor cell by using known characteristic.

[Effect of the Invention]

According to the present invention, a solar cell output characteristic evaluation apparatus and a method thereof capable of accurately measuring an open-circuit voltage Voc by applying a forward bias current with a minimum power consumption without requiring a bipolar power supply discharging/absorbing a large current causing a cost increase are provided.

[Brief Description of the Drawing]

[FIG1]

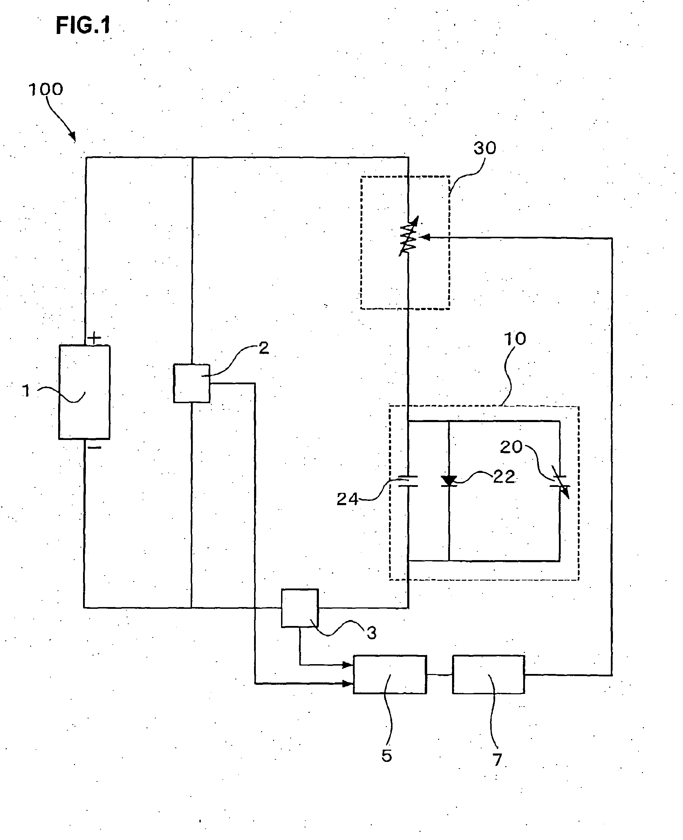

FIG 1 is an explanatory view of a conventional solar cell I-V curve tracer 100.
[FIG 2]

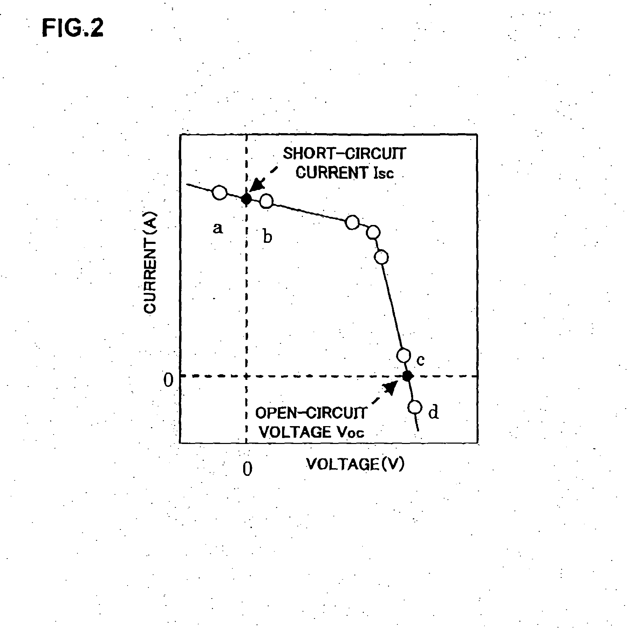

FIG 2 is a graphic chart of I-V characteristic being a measurement result of the solar cell I-V curve tracer 100 when a solar cell I is at a certain irradiance.
[FIG 3]

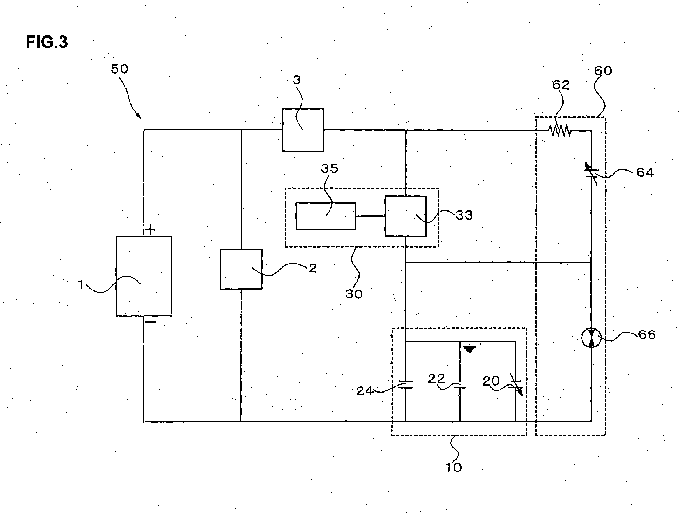

FIG 3 is an explanatory view of a solar cell output characteristic evaluation apparatus 50.
[FIG 4]

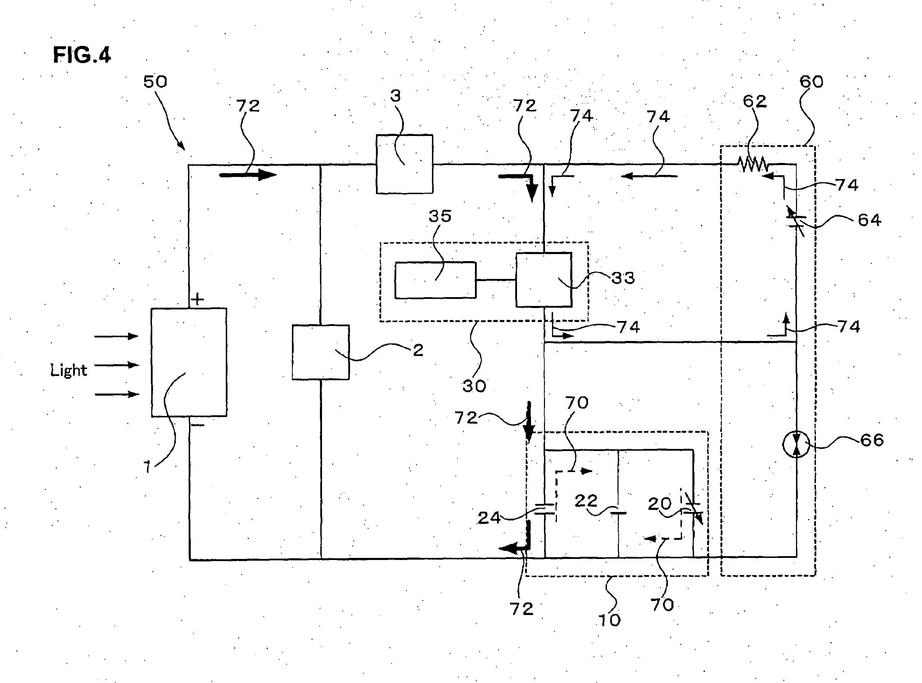

FIG 4 is a process to obtain a short-circuit current Isc when an I-V characteristic measurement is performed by using the solar cell output characteristic evaluation apparatus 50.
[FIG 5]

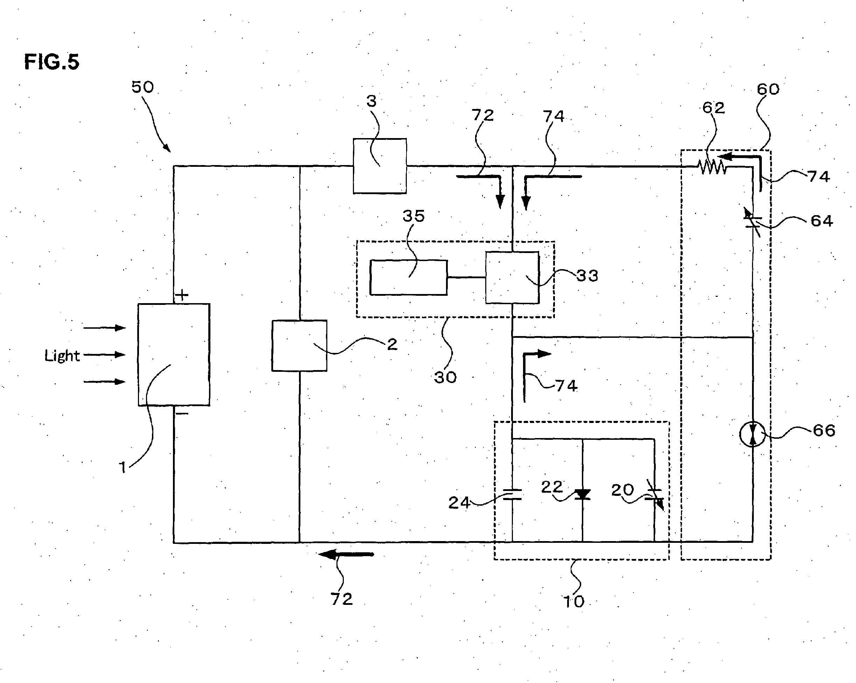

FIG 5 is an explanatory view as for a process to obtain an open-circuit voltage Voc when the I-V characteristic measurement is performed by using the solar cell output characteristic evaluation apparatus 50.
[FIG 6]

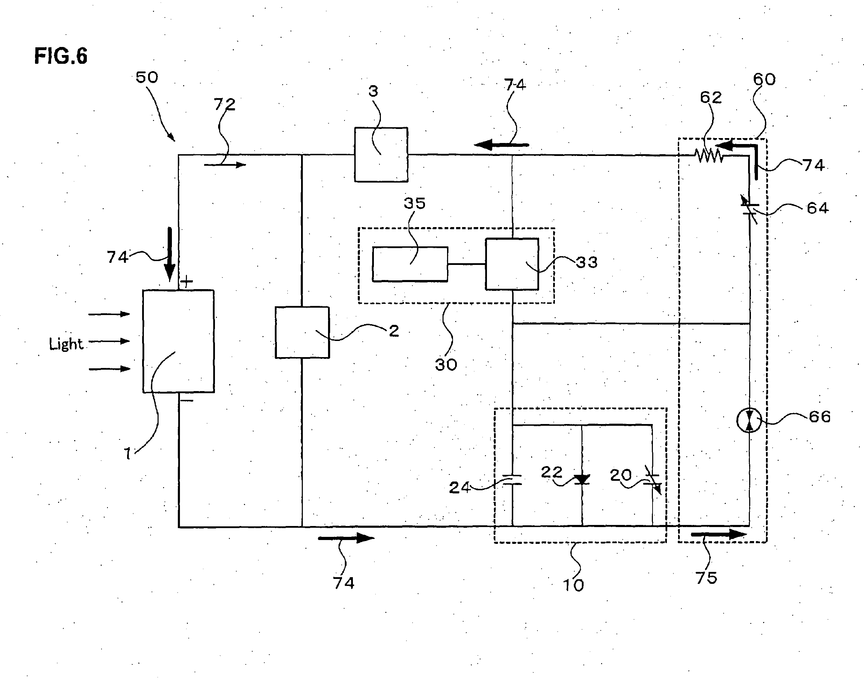

FIG 6 is a flowchart of a current at a forward bias operation time.
[FIG 7]

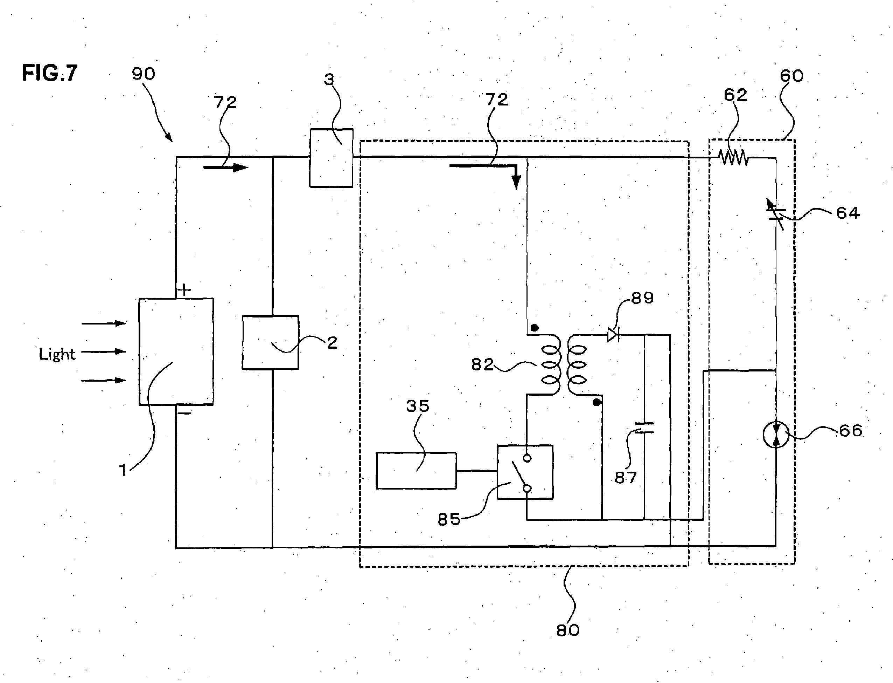

FIG 7 is an explanatory view of a high capacity electronic load device 90 using a switching system.

[Explanation of Codes]

1      solar cell
2      voltmeter
3      ammeter
10     reverse bias circuit
20     reverse bias power supply
30     variable resistor part
50     solar cell output characteristic evaluation apparatus
60     forward bias circuit
80     power conversion circuit with reverse bias
90     high capacity electronic load device
100    principle chart of solar cell I-V curve tracer with reverse bias

[Best Mode for Carrying out the Invention]

Hereinafter, embodiments of the present invention are described with reference to the drawings. Note that the same reference numeral and symbols are added to components having substantially the same function, and redundant description thereof is not given in the specification and the drawings.

At first, a conventional solar cell I-V curve tracer is described below FIG 1 is an explanatory view of a conventional solar cell I-V curve tracer 100 invented by the present inventors. A voltmeter 2 measuring an output voltage and an ammeter 3 measuring an output current are connected to a solar cell 1. Besides, a reverse bias circuit 10 made up of a reverse bias power supply 20, a backflow preventing diode 22, a reverse bias stabilizing capacitor 24 arranged in parallel is provided at upstream of the ammeter 3. Besides, a variable resistor part 30 of the solar cell 1 is provided at downstream (at upstream of the reverse bias circuit 10) of the solar cell 1. A high-speed converter 5 and a data processing variable resistor controller 7 performing a solar cell output measurement are connected to the voltmeter 2 and the ammeter 3.

Besides, FIG 2 is a graphic chart of I-V characteristic being a measurement result of the solar cell I-V curve tracer 100 when the solar cell 1 is at a certain irradiance. In the measurement of the I-V characteristic, a load resistance value of the variable resistor part is operated within a range of "0" (zero) to ∞, the I-V characteristic at that time are measured and a graph is made to perform a characteristic evaluation. Note that an output current when the load resistance value is small, namely, when the output voltage of the solar cell 1 is set at "0" (zero) V is a short-circuit current Isc, and the output voltage when the load resistance value is the maximum, namely, when the output current of the solar cell 1 is set at "0" (zero) A is an open-circuit voltage Voc.

In the solar cell I-V curve tracer 100 illustrated in FIG 1, it is impossible to accurately measure the short-circuit current Isc because the output voltage of the solar cell I does not actually become "0" (zero) V resulting from a connecting wire resistance or the like and it is just lowered to a certain voltage (a point "b" in FIG 2) even if the output voltage of the solar cell 1 is tried to be set at "0" (zero) V when the I-V characteristic are measured under a state without providing the reverse bias circuit 10.
Accordingly, the reverse bias circuit 10 illustrated in FIG 1 is provided, and it becomes possible to lower the output voltage to "0" (zero) V or less (for example, a point "a" in FIG 2) by applying a reverse voltage of the output voltage of the solar cell 1. As a result, it becomes possible to accurately perform the measurement of the short-circuit current Isc.

On the other hand, it is impossible to accurately measure the open-circuit voltage Voc because the output current of the solar cell 1 does not become "0" (zero) A resulting from a characteristic of the variable resistor part 30 and it is just lowered to a certain current (a point "c" in FIG 2) even if the output current of the solar cell 1 is, tried to be set at "0" (zero) A when the solar cell I-V curve tracer 100 illustrated in FIG 1 is used.

A solar cell output characteristic evaluation apparatus 50 according to an embodiment of the present invention described below is therefore proposed. FIG 3 is an explanatory view of the solar cell output characteristic evaluation apparatus 50 according to the embodiment of the present invention. The voltmeter 2 measuring the output voltage and the ammeter 3 measuring the output current are connected to the solar cell 1. Besides, the variable resistor part 30 and the reverse bias circuit 10 are connected at downstream of the ammeter 3 as same as the solar cell I-V curve tracer 100. Here, the variable resistor part 30 is made up of a load power semiconductor 33 being, for example, an HFET (Hetero structure Field Effect Transistor) and an electronic load control circuit 35. Further, a forward bias circuit 60 is connected at downstream of the ammeter 3 so as to be in parallel with the variable resistor part 30 and the reverse bias circuit 10 relative to the solar cell 1. Here, a constitution of the reverse bias circuit 10 is as same as the above-stated I-V curve tracer. A constitution of the forward bias circuit 60 is the one in which a forward bias resistor 62, a forward bias power supply 64, and a forward bias parasitic current compensation circuit 66 are connected from a circuit upstream side. A downstream side of the forward bias circuit 60 is connected to the reverse bias circuit 10, and between the forward bias power supply 64 and the forward bias parasitic current compensation circuit 66 inside the forward bias circuit 60 and between the variable resistor 30 and the reverse bias circuit 10 are connected.

Hereinafter, a process measuring the I-V characteristic by using the solar cell output characteristic evaluation apparatus 50 according to a first embodiment constituted as illustrated in FIG 3 is described with reference to the drawings.

FIG. 4 is an explanatory view as for a process to obtain the short-circuit current Isc when the I-V characteristic measurement is performed by using the solar cell output characteristic evaluation apparatus 50.
The constitutions of respective parts in FIG 4 are the same as the above, and the description is not given. Besides, a current output from the solar cell 1 is represented by "72" (a solid arrow 72), and a forward bias current output from the forward bias power supply 64 is represented by "74" (a solid arrow 74) in FIG 4.

Just before the I-V characteristic measurement is performed, a charge is performed for the reverse bias stabilizing capacitor 24 by the reverse bias power supply 20 with a reverse polarity of the output of the solar cell 1 in the reverse bias circuit 10 as represented by a dotted line 70 in FIG 4.
A reverse bias voltage is applied to the solar cell 1 by an electric charge voltage charged to the reverse bias stabilizing capacitor 24 when the I-V characteristic measurement is started. At this time, a value at the point "a" in FIG 2 is observed at the voltmeter 2. Note that the solar cell output current 72 at this time flows via the load power semiconductor 33 and the reverse bias stabilizing capacitor 24.

After that, a control to enlarge a load resistance value of the solar cell 1 is performed by the load power semiconductor 33 controlled by the electronic load control circuit 35, and the voltage charged to the reverse bias stabilizing capacitor 24 is rapidly discharged. At this time, a, voltage in reverse direction is applied to the reverse bias stabilizing capacitor 24, but the voltage in reverse direction is not applied to the reverse bias stabilizing capacitor 24 because the voltage in reverse direction is clamped to a forward direction voltage of the backflow preventing diode 22 owing to an effect of the backflow preventing diode 22.

The value of the voltmeter 2 changes from the point "a" to the point "b" during the above-stated process. A change of value of the ammeter 3 in accordance with the change of the value of the voltmeter 2 is measured, and thereby, it becomes possible to accurately obtain the short-circuit current Isc being the value of the ammeter 3 when the voltage of the solar cell 1 is set at "0" (zero) V Note that, at this time, the forward bias current 74 from the forward bias circuit 60 does not flow toward the solar cell 1 but flows toward the load power semiconductor 33 because a resistance value of the variable resistor 30 is small. The forward bias current 74 returns to the forward bias power supply 64 via the load power semiconductor 33.

Besides, FIG 5 is an explanatory view as for a process to obtain the open-circuit voltage Voc when the I-V characteristic measurement is performed by using the solar cell output characteristic evaluation apparatus 50. The constitutions of respective parts in FIG 5 are the same as the above, and the description is not given. Besides, a current output from the solar cell 1 is represented by "72" (a solid arrow 72), and a forward bias current output from the forward bias power supply 64 is represented by "74" (a solid arrow 74) in FIG 5.

A control to enlarge the load resistance value of the solar cell 1 is performed by the load power semiconductor 33 controlled by the electronic load control circuit 35, and the current does not flow toward the load power semiconductor 33. At this time, the current measured by the ammeter 3 changes from the point "c" to a point "d" in FIG 2 as the load resistance value of the solar cell 1 becomes large. The value of the voltmeter 2 during this process is measured, and thereby, it becomes possible to accurately obtain the open-circuit voltage Voc when the output current of the solar cell 1 is set at "0" (zero) A. Note that the forward bias current 74 returns to the forward bias power supply 64 when the load resistance value of the solar cell 1 exceeds the open-circuit voltage Voc and approximates to the point "d" in FIG 2

FIG 6 is a flowchart of the current at a forward bias operation time. Here, the forward bias current 74 flows into the solar cell 1 and stored at the reverse bias stabilizing capacitor 24 as illustrated in FIG 6 when the load resistance value of the load power semiconductor 33 becomes the maximum under a state when light is not supplied to the solar cell 1 before the I-V characteristic measurement is performed. The forward bias parasitic current compensation circuit 66 is therefore provided to make the forward bias current 74 flow via the forward bias parasitic current compensation circuit 66 as represented by an arrow 75 in FIG 6. The forward bias current 74 is supplied and stored at the reverse bias stabilizing capacitor 24 if the forward bias parasitic current compensation circuit 66 does not exist As a result, the charge is performed over a withstand voltage of the reverse bias stabilizing capacitor 24, and it may incur a risk of breakdown of the reverse bias stabilizing capacitor 24.

It becomes possible to perform more accurate evaluation as for the I-V characteristic of the solar cell 1 by accurately measuring the short-circuit current Isc and the open-circuit voltage Voc through the process measuring the I-V, characteristic by using the solar cell output characteristic evaluation apparatus 50 as stated above.

Hereinabove an example of the embodiment of the present invention is described, but the present invention is not limited to the illustrated embodiment. It is obvious that those skilled in the art are able to figure out various changed examples or modified examples within the range of the following claims, and it is to be understood that all those changes and modifications are to be included in the technical scope of the present invention.

For example, it is preferable that a restricting function capable of restricting a maximum output voltage of the forward bias power supply 64 in the forward bias circuit 60 is to be added to perform the evaluation of various solar cells by the same solar cell output characteristic evaluation apparatus. A small-size and low capacity solar cell is also manufactured while a large-size and high capacity solar cell has been enabled. When the I-V. characteristic measurement is performed by the solar cell output characteristic evaluation apparatus 50 described in the above-stated embodiment in the small-size solar cell, an overvoltage is applied to the solar cell 1 caused by the voltage from the forward bias power supply 64 inside the forward bias circuit 60, and there is a possibility that the solar cell 1 is broken. Accordingly, it is conceivable to enable to control the maximum output voltage so that the output voltage from the forward bias power supply 64 becomes an adequate voltage corresponding to the small-size solar cell and so on.

Besides, when the output- voltage and the output current output from the solar cell 1 are output over ratings of the voltmeter 2 and the ammeter 3, it may cause troubles or the like of the voltmeter 2, the ammeter 3 and the load power semiconductor 33. Accordingly, it is also conceivable that observed values of the voltmeter 2 and the ammeter 3 are monitored at the electronic load control circuit 35, comparisons between respective observed values and the rated values of the voltmeter 2 and the ammeter 3 are performed, and it is controlled so that the observed values of the voltmeter 2 and the ammeter 3 do not exceed the rated values by controlling the load power semiconductor 33 when the observed value exceeds the rated value in the comparison.

It is also conceivable that a high capacity electronic load device using a switching system is used as the reverse bias circuit in the above-stated embodiment to accurately obtain the short-circuit current Isc.

A high capacity electronic load device 90 using the switching system is described below with reference to the drawings.

FIG. 7 is an explanatory view of the high capacity electronic load device 90 using the switching system according to the present invention. A constitution of the high capacity electronic load device 90 is as same as the above-stated embodiment except the reverse bias circuit 10 and the variable resistor part 30, and therefore, the description is not given. As illustrated in FIG 7, a power conversion circuit with reverse bias 80 is provided at downstream of the ammeter 3 in the high capacity electronic load device 90.

The power conversion circuit with reverse bias 80 is made up of a load switching circuit 85, a switching transformer 82, a backflow preventing diode 89 and a reverse bias stabilizing capacitor 87.

The switching system means that a rate of turning ON/OFF of an electronic switch is changed effectively to control electric power to the load. The load switching circuit 85 using the switching system is a load when it is seen from a power supply side, and it is possible to artificially lower the load of the solar cell 1 from the infinite while regarding the switching power load as an electronic load. However, an extremely low resistance value of the solar cell 1 cannot be achieved by using only the load switching circuit 85 using the switching system, and the short-circuit current Isc cannot be accurately measured.

A reverse bias circuit corresponding to the switching system is therefore provided to obtain the short-circuit current Isc. The process is described below.

Just before the I-V characteristic measurement is performed, the current does not flow in the switching transformer 82, and therefore, the reverse bias stabilizing capacitor 87 is not charged.

After that, the load switching circuit 85 is controlled by the electronic load control circuit 35 so that the load resistance value of the solar cell 1 is to be the minimum from the infinite when the I-V characteristic measurement is started. At this time, the load resistance value of the solar cell 1 gradually decreases from the infinite, and therefore, the solar cell output current 72 flows. A voltage is applied to the switching transformer 82 by the solar cell output current 72, and the charge with the reverse polarity of the output of the solar cell 1 is performed to the reverse bias stabilizing capacitor 87.

When the load resistance value of the solar cell 1 approximates to the minimum, the output voltage of the solar cell 1 approximates to "0" (zero) V, and the reverse bias is applied to the solar cell 1 caused by the electric charge voltage charged to the reverse bias stabilizing capacitor 87. At this time, the value at the point "b" in FIG 2 is observed at the voltmeter 2. Note that the voltages of the reverse bias power supply 89 and the reverse bias stabilizing capacitor 87 are applied to the switching transformer 82 and the load switching circuit 85, and therefore, the switching circuit operation continues.

When the.load resistance value of the solar cell 1 becomes "0" (zero), the reverse bias is applied to the solar cell 1 caused by the electric charge voltage charged to the reverse bias stabilizing capacitor 87. Accordingly, the value at the point "a" in FIG 2 is observed at the voltmeter 2.

The value of the voltmeter 2 changes from the point "b" to the point "a" in FIG. 2 during the above-stated process. The value of the ammeter 3 at this time is observed, and thereby, it becomes possible to accurately obtain the short-circuit current Isc when the output voltage of the solar cell 1 is set at "0" (zero) V

Besides, the open-circuit voltage Voc when the output current of the solar cell I is set at "0" (zero) A can be obtained accurately by using the forward bias circuit 60 having the similar constitution as the above-stated embodiment in the high capacity electronic load device 90 using the switching system. The process thereof is the same as the above-stated embodiment, and therefore, the description is not given.

On the other hand, it is generally known that a noise component is contained in measurement data of the I-V characteristic measurement of the solar cell depending on a measurement environment. It is also conceivable that a method removing the noise component from the obtained measurement data is applied to the present invention to perform the more accurate I-V characteristic measurement of the solar cell. A characteristic function representing the characteristic thereof is well known in the solar cell, and a result to be obtained can be expected. The noise component can be removed from each measurement data based on expected information. Removal of the noise component is described below.

The solar cell I-V characteristic measurement data measured by an electronic load device are the output voltage of the solar cell, the output current of the solar cell, actual measurement values of a monitor cell, and so on. Note that the monitor cell is a cell of which conversion factor is accurately measured in advance, and of which relationship between the output current and light intensity is obvious.

Parameters are determined so that each measurement data most approximates to a known function as for each measurement data. Here, the known function is a function having theoretical and principle validity, and a polynomial approximation, a learning result of a neuro-computer, a table search, and so on are conceivable as for the parameter determination.

For example, when a quadratic expression approximation is applied as the known function, coefficients "a", "b", "c" in "y = ax$^2$ + bx + c" are found from the measurement data. It becomes possible to accurately obtain the solar cell output voltage, the solar cell output current from the parameters by using the quadratic expression determined by the found coefficients "a", "b", "c".

According to this method, values of Isc, Voc, Pmax, Vpm, Ipm, FF, EFF, and so on can be found by a calculation from the found coefficients. Besides, conventionally, the data as for the I-V characteristic in every case should be stored to reproduce the measurement data, but only the obtained parameters are to be stored in this method.

It is desirable to perform more accurate light intensity correction as for the output of the solar cell of which noise component is removed.

In the characteristic evaluation of the solar cell, the light intensity decreases as time passes when a flash lamp is used. Accordingly, the light intensity correction is required for the output of the solar cell. Hereinafter, it is described that the light intensity is corrected such that an irradiance is measured at 1000 ± 50 W/m$^2$.

At first, before the light intensity correction is performed, the measurement is performed in a time zone when adequate light intensity is output by the output current of the monitor cell. Here, it is the time zone when the irradiance is at 1000 ±50 W/m$^2$. The I-V characteristic measurement of the solar cell is performed at this time zone. In this case, the time zone when the light intensity is output correctly is short, and therefore, the measurements are performed for plural times while shitting timings to start the I-V characteristic measurements. A measurement voltage is sequentially increased from a short-circuit state to the open-circuit voltage Voc for the data measured when the adequate light intensity is output.

Next, the light intensity correction of the output current of the solar cell is performed. In this case, a value of the light intensity is ±5% or less, and therefore, the light intensity correction of the output current of the solar cell may be performed by using a proportional correction. The solar cell I-V characteristic is created based on the data obtained by the above-stated measurements. Note that the solar cell I-V characteristic created here is called as a reference curve.

The solar cell I-V characteristic measurement of a new solar cell with the same characteristic is performed within a range of the light intensity of ±20%. Here, the measurement is performed once, and the noise removal is performed as for the measurement data The light intensity correction of the output current of the solar cell is performed by using the obtained data. The output current of the solar cell is represented by the following expression, but this expression is a nonlinear type, and therefore, an analytic light intensity correction is difficult.

[Expression 1]

$$i = i_{ph} - I_o \left\{ \exp \left[ \frac{q(v + i \cdot r_s)}{n_d k T} \right] \cdot 1 \right\} - \frac{(v + i \cdot r_s)}{r_{sh}}$$

| | | | | | |
|---|---|---|---|---|---|
| i | : | output current of solar cell | r$_a$ | : | series resistance of solar cell |
| i$_{ph}$ | : | photocurrent of solar cell | n$_d$ | : | diode factor |
| i$_o$ | : | reverse saturation current of diode | k | : | Boltzmann constant |
| q | : | elementary charge | T | : | absolute temperature of solar cell |
| v | : | solar cell output voltage | r$_{sh}$ | : | parallel resistance of solar cell |

The light intensity correction of the output current of the solar cell is performer based on the following expression. Namely, an output current value "in" of the solar cell is found by using a proceeding current value "in - 1".

[Expression 2]

$$i_n = i_{ph} - I_0 \left\{ \exp \left[ \frac{q(v + i_{n-1} \cdot r_s)}{n_d k T} \right] - 1 \right\} - \frac{(v + i_{n-1} \cdot r_s)}{r_{sh}}$$

Further, a table capable of setting appropriate values for each is prepared in advance as for the diode factor $n_d$, the series resistance $r_s$ of the solar cell, the parallel resistance $r_{5h}$ of the solar cell. The I-V characteristic of the solar cell is obtained based on the values set at the table.

Here, the solar cell I-V characteristic with the most consistency, having the consistency with the solar cell I-V characteristic called as the reference curve is to be determined in advance to judge which parameter is appropriate. After that, the parameters are applied and calculated to the measurement result.

[Industrial Applicability]

The present invention is applicable for a solar cell output characteristic evaluation apparatus and a solar cell output characteristic evaluation method including a forward bias power supply supplying to an electronic load device for a solar cell output characteristic measurement.

**Claims**

1.  A solar cell output characteristic evaluation apparatus measuring output characteristic of a solar cell, comprising:

    a solar cell;
    a voltmeter measuring a voltage of the solar cell;
    an ammeter measuring a current value flowing in the solar cell;
    a variable resistor part connected to the solar cell;
    a forward bias circuit connected to the solar cell; and
    a reverse bias circuit connected to the solar cell.

2.  The solar cell output characteristic evaluation apparatus According to claim 1,
    wherein the variable resistor part is made up of an electronic load control circuit and a load power semiconductor.

3.  The solar cell output characteristic evaluation apparatus according to claim 1,
    wherein the forward bias circuit is made up of a forward bias resistor, a forward bias power supply, and a forward bias parasitic current compensation circuit.

4.  The solar cell output characteristic evaluation apparatus according to claim 1,
    wherein the variable resistor part and the reverse bias circuit are included in a power conversion circuit with reverse bias, and the power conversion circuit with reverse bias is made up of a switching transformer, a backflow preventing diode, a reverse bias stabilizing capacitor, and a load circuit.

5.  A solar cell output characteristic evaluation method connecting a voltmeter, an ammeter, and an electronic load being a variable resistor to a solar cell, and obtaining a current-voltage characteristic of the solar cell by changing the electronic load, comprising:

    applying a reverse bias voltage in reverse of an output of the solar cell,
    applying a forward bias voltage to the solar cell; and
    measuring a short-circuit current and an open-circuit voltage of the solar cell.

6.  The solar cell output characteristic evaluation method according to claim 5,
    wherein a function restricting a maximum output voltage is added to the forward bias power supply in the applying the forward bias voltage.

7. The solar cell output characteristic evaluation method according to claim 6,
wherein a high capacity electronic load device using a switching system is used as the variable resistor.

8. The solar cell output characteristic evaluation method according to claim 5,
wherein a noise component is removed from an output voltage and an output current obtained from the solar cell and an actual measurement value of a monitor cell by using known characteristic.

**FIG.1**

FIG.2

**FIG.3**

FIG.4

EP 2 287 918 A2

**FIG.5**

EP 2 287 918 A2

14

**FIG.6**

EP 2 287 918 A2

**FIG.7**

EP 2 287 918 A2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI2159588 B